# EUROPEAN PATENT APPLICATION

(11) **EP 4 432 790 A1**
(43) Date of publication of application: **18.09.2024**
(21) Application number: 22892864.4
(22) Date of filing: 10.11.2022
(51) Int. Cl.: H05K 1/11, H05K 3/40

(54) **THROUGH-VIA SUBSTRATE, MOUNTING SUBSTRATE, AND METHOD FOR MANUFACTURING THROUGH-VIA SUBSTRATE**

(30) Priority: 10.11.2021 JP 2021183653
(71) Applicant: Dai Nippon Printing Co., Ltd., Tokyo 162-8001 (JP)
(72) Inventor: KURAMOCHI, Satoru, Tokyo 162-8001 (JP)
(74) Representative: Müller-Boré & Partner Patentanwälte PartG mbB
(86) International application number: PCT/JP2022/041942
(87) International publication number: WO 2023/085366

(57) **Abstract**

A through-via substrate includes a substrate and a through via. The substrate includes a first surface and a second surface located on a side opposite to the first surface. The substrate is provided with a through hole including a wall surface extending from the first surface to the second surface. The through via is located in the through hole. The through via extends from the first surface to the second surface. The through via includes a seed layer, a first portion, and a second portion. The seed layer is located on the wall surface. The seed layer spreads along the wall surface from the first surface toward the second surface. The first portion covers the seed layer. The second portion touches the first portion at an interface traversing the through hole.

## Description

### Technical Field

An embodiment of the present disclosure relates to a through-via substrate, a mounting substrate, and a method for manufacturing a through-via substrate.

### Background Art

Through-via substrates are used for various purposes. A through-via substrate includes a substrate provided with through holes and electrodes located in the through holes. For example, a through-via substrate is used as an interposer that is interposed between two LSI chips. Further, a through-via substrate may be interposed between an element such as an LSI chip and a mounting substrate such as a motherboard. It should be noted that an electrode provided inside a through hole may be hereinafter referred to as "through via".

### Citation List

### Patent Literature

PTL 1: Japanese Unexamined Patent Application Publication No. 2020-61554

### Summary

Known examples of through vias are filled vias or conformal vias. A filled via contains a conducting material such as copper charged into a through hole. A conformal via includes a conductive layer that spreads along a wall surface of a through hole. In terms of reducing electrical resistance, filled vias are preferred. However, in a case where a filled via is formed by a plating process, a void tends to be formed. A void is a hole defect that is formed inside a filled via. A void is formed in a case where the speed of growth of plating inside a through hole is not adequately controlled.

An embodiment of the present disclosure was made in view of such a point and has as an object to provide a through-via substrate including through vias with reduced voids.

The embodiment of the present disclosure relates to (1) to (21) below.
(1) A through-via substrate including:
   a substrate including a first surface and a second surface located on a side opposite to the first surface, the substrate being provided with a through hole including a wall surface extending from the first surface to the second surface; and
   a through via located in the through hole, the through via extending from the first surface to the second surface,
   wherein the through via includes
      a seed layer located on the wall surface, the seed layer spreading along the wall surface from the first surface toward the second surface,
      a first portion covering the seed layer, and
      a second portion touching the first portion at an interface traversing the through hole.
(2) In the through-via substrate according to (1), a dimension of the first portion may be smaller than a dimension of the second portion in a thickness direction of the substrate.
(3) In the through-via substrate according to (1) or (2), a ratio T11/T0 of a dimension T11 of the seed layer in the thickness direction of the substrate to a thickness T0 of the substrate may be 0.025 or higher and 0.275 or lower.
(4) In the through-via substrate according to any one of (1) to (3), the interface may include a depression depressed toward the first surface.
(5) In the through-via substrate according to any one of (1) to (4), a ratio T0/R1 of a thickness T0 of the substrate to a dimension R1 of the through hole at the first surface may be 3.0 or higher and 25.0 or lower.
(6) In the through-via substrate according to any one of (1) to (5), a thickness of the seed layer may be 5 nm or greater and 50 nm or less.
(7) In the through-via substrate according to any one of (1) to (6), the first portion may include a superconducting material containing at least one element selected from the group consisting of Nb, Pb, Ta, Sn, In, and Al.
(8) In the through-via substrate according to any one of (1) to (7), the second portion may include a superconducting material containing at least one element selected from the group consisting of Nb, Pb, Ta, Sn, In, and Al.
(9) The through-via substrate according to any one of (1) to (8) may further include a first pad located at the first surface so as to cover the through hole in a plan view and connected to the first portion.
(10) In the through-via substrate according to (9), the first pad may include a superconducting material containing at least one element selected from the group consisting of Nb, Pb, Ta, Sn, In, and Al.
(11) In the through-via substrate according to (9) or (10), the first pad may be integrated with the first portion.
(12) In the through-via substrate according to any one of (9) to (11), the first pad may cover the through hole in a plan view.
(13) The through-via substrate according to any one of (9) to (12) may further include a first inorganic layer located on the first surface, the first inorganic layer being adjacent to the first pad in a plane direction and containing an inorganic insulating material.
(14) The through-via substrate according to any one of (1) to (13) may further include a first wire located on the first surface and connected to the first portion.
(15) In the through-via substrate according to (14), the first wire may include a superconducting material containing at least one element selected from the group consisting of Nb, Pb, Ta, Sn, In, and Al.
(16) In the through-via substrate according to (14) or (15), the first wire may be integrated with the first portion.
(17) A mounting substrate including:
   the through-via substrate according to any one of (1) to (16); and
   an element electrically connected to the through via of the through-via substrate.
(18) In the mounting substrate according to (17), the element may include a quantum chip containing a quantum bit.
(19) A method for manufacturing a through-via substrate, the method including:
   a step of preparing a substrate including a first surface and a second surface located on a side opposite to the first surface, the substrate being provided with a through hole including a wall surface extending from the first surface to the second surface; and
   a through-via forming step of forming a through via in the through hole,
   wherein
   the through-via forming step includes
      a step of forming a seed layer located on the wall surface, the seed layer spreading along the wall surface from the first surface toward the second surface,
      a step of forming a first plated portion through a first plating process that involves use of a first plating solution, the first plated portion covering the seed layer, and
      a step of forming a second plated portion through a second plating process that involves use of a second plating solution, the second plated portion touching the first plated portion, and
   the second plated portion touches the first plated portion at an interface traversing the through hole.
(20) In the method according to (19), the first plating solution may include a superconducting material containing at least one element selected from the group consisting of Nb, Pb, Ta, Sn, In, and Al.
(21) In the method according to (19) or (20), the second plating solution may include a superconducting material containing at least one element selected from the group consisting of Nb, Pb, Ta, Sn, In, and Al.

The embodiment of the present disclosure makes it possible to provide a through-via substrate including through vias with reduced voids.

### Brief Description of Drawings

[Fig. 1] Fig. 1 is a cross-sectional view showing a mounting substrate according to a first embodiment.
[Fig. 2] Fig. 2 is an enlarged cross-sectional view showing a through-via substrate according to the first embodiment.
[Fig. 3] Fig. 3 is a cross-sectional view showing a process for manufacturing a through-via substrate according to the first embodiment.
[Fig. 4] Fig. 4 is a cross-sectional view showing the process for manufacturing a through-via substrate according to the first embodiment.
[Fig. 5] Fig. 5 is a cross-sectional view showing the process for manufacturing a through-via substrate according to the first embodiment.
[Fig. 6A] Fig. 6A is a cross-sectional view showing the process for manufacturing a through-via substrate according to the first embodiment.
[Fig. 6B] Fig. 6B is a cross-sectional view showing the process for manufacturing a through-via substrate according to the first embodiment.
[Fig. 7] Fig. 7 is a cross-sectional view showing the process for manufacturing a through-via substrate according to the first embodiment.
[Fig. 8] Fig. 8 is a cross-sectional view showing the process for manufacturing a through-via substrate according to the first embodiment.
[Fig. 9] Fig. 9 is a cross-sectional view showing the process for manufacturing a through-via substrate according to the first embodiment.
[Fig. 10] Fig. 10 is a cross-sectional view showing a process for manufacturing a through-via substrate according to a first modification.
[Fig. 11] Fig. 11 is a cross-sectional view showing the process for manufacturing a through-via substrate according to the first modification.
[Fig. 12] Fig. 12 is a cross-sectional view showing the process for manufacturing a through-via substrate according to the first modification.
[Fig. 13] Fig. 13 is a cross-sectional view showing the process for manufacturing a through-via substrate according to the first modification.
[Fig. 14] Fig. 14 is a cross-sectional view showing a process for manufacturing a through-via substrate according to a second modification.
[Fig. 15] Fig. 15 is a cross-sectional view showing the process for manufacturing a through-via substrate according to the second modification.
[Fig. 16] Fig. 16 is a cross-sectional view showing the process for manufacturing a through-via substrate according to the second modification.
[Fig. 17] Fig. 17 is a diagram showing examples of products in which a through-via substrate is mounted.
[Fig. 18] Fig. 18 is a diagram showing conditions of manufacture of through-via substrates in examples and results of evaluation of the through-via substrates.
[Fig. 19] Fig. 19 is a diagram showing conditions of manufacture of through-via substrates in examples and results of evaluation of the through-via substrates.
[Fig. 20] Fig. 20 is a diagram showing conditions of manufacture of through-via substrates in examples and results of evaluation of the through-via substrates.
[Fig. 21] Fig. 21 is a diagram showing conditions of manufacture of through-via substrates in examples and results of evaluation of the through-via substrates.

### Description of Embodiments

In the following, a through-via substrate, a mounting substrate, and a method for manufacturing a through-via substrate according to an embodiment of the present disclosure are described in detail with reference to the drawings. The embodiment to be described below is an example of an embodiment of the present disclosure, and the present disclosure should not be construed as being limited to such embodiments. Terms such as "parallel" and "orthogonal", values of length and angle, or other terms and values that are used herein to specify shapes, geometric conditions, and their extent are not bound by strict meanings but construed as encompassing the extent to which similar functions may be expected.

In a case where a plurality of upper-limit candidates and a plurality of lower-limit candidate are lined up herein for a parameter, the range of numerical values of the parameter may be constituted by a combination of any one of the upper-limit candidates and any one of the lower-limit candidates. Let some through be given to a case of the following statement: "A parameter B is for example A1 or greater, may be A2 or greater, or may be A3 or greater. The parameter B is for example A4 or less, may be A5 or less, or may be A6 or less." In this case, the range of numerical values of the parameter B may be A1 or greater and A4 or less, may be A1 or greater and A5 or less, may be A1 or greater and A6 or less, may be A2 or greater and A4 or less, may be A2 or greater and A5 or less, may be A2 or greater and A6 or less, may be A3 or greater and A4 or less, may be A3 or greater and A5 or less, or may be A3 or greater and A6 or less.

In the drawings that are referred to in the embodiment, identical components or components having similar functions may be assigned identical or similar signs, and a repeated description of such components may be omitted. Further, for convenience of explanation, dimensional ratios in the drawings may be different from actual ratios, or some components may be omitted from the drawings.

### (Mounting Substrate)

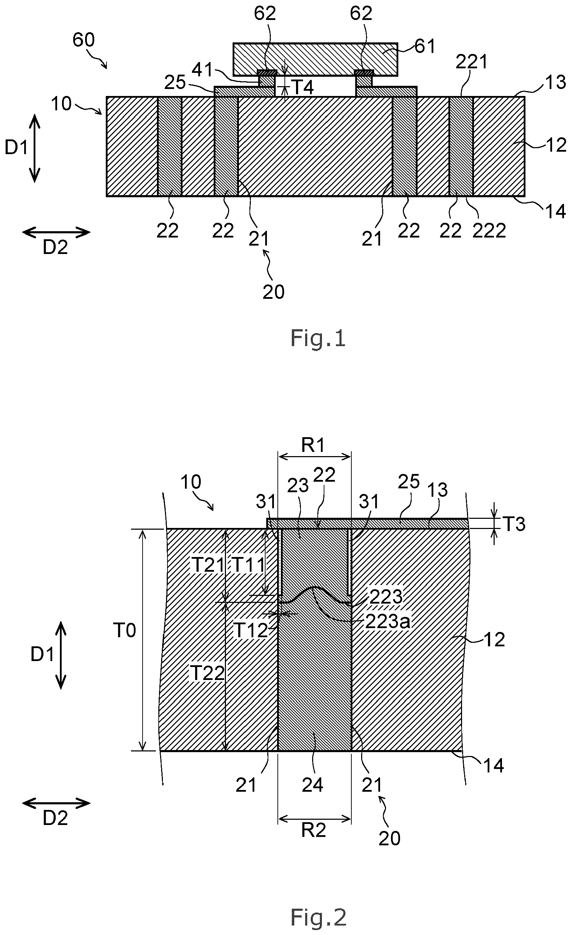

Fig. 1 is a cross-sectional view showing an example of a mounting substrate 60. The mounting substrate 60 includes a through-via substrate 10 and an element 61. The element 61 may be an LSI chip such as a logic IC or a memory IC. The element 61 may be a MEMS (Micro Electro Mechanical Systems) chip. The MEMS chip is an electronic device in which a mechanical element, a sensor, an actuator, an electronic circuit, or other devices are integrated on one substrate. The element 61 includes terminals 62 electrically connected to the through-via substrate 10.

The element 61 may include a quantum chip. The quantum chip functions as a quantum computer. The quantum computer is a computer configured to process information through the utilization of a quantum-mechanical phenomenon. The quantum chip contains a quantum bit. The quantum bit is a minimum unit of quantum information. The quantum bit is not limited to particular structures. For example, the quantum bit may be constituted by a circuit containing a superconducting material.

The element 61 may include a superconducting chip. The superconducting chip is a chip that is driven through the utilization of a superconducting phenomenon. The superconducting phenomenon is for example a permanent current.

Although not illustrated, the mounting substrate 60 may include a cooling device. The cooling device cools the through-via substrate 10 and the element 61. In a case where the through-via substrate 10 or the element 61 contains a superconducting material, the through-via substrate 10 and the element 61 may be cooled to superconducting transition temperature or lower. The superconducting transition temperature is a temperature at which a superconducting material assumes a superconductive state. The superconducting transition temperature may be 77 K or lower.

### (Through-via Substrate)

As shown in Fig. 1, the through-via substrate 10 includes a substrate 12, through vias 22, first wires 25, and post pads 41.

### (Substrate)

The substrate 12 includes a first surface 13 and a second surface 14. The second surface 14 is located on the side opposite to the first surface 13. As shown in Fig. 1, the element 61 may be located over the first surface 13. Although not illustrated, the element 61 may be located over the second surface 14.

The substrate 12 is provided with a plurality of through holes 20 passing through the substrate 12. Each of the through holes 20 includes a wall surface 21. The wall surface 21 extends from the first surface 13 to the second surface 14. A direction from the first surface 13 toward the second surface 14 is hereinafter also referred to as "thickness direction D1". The thickness direction D1 may be parallel to the normal to the first surface 13. A direction in which the first surface 13 spreads is also referred to as "plane direction D2".

The substrate 12 is made from an inorganic material having insulating properties. Examples of the substrate 12 include a glass substrate, a quartz substrate, a sapphire substrate, a resin substrate, a silicon substrate, a silicon carbide substrate, an alumina (Al₂O₃) substrate, an aluminum nitride (AIN) substrate, and a zirconium oxide (ZrO₂) substrate.

In a case where the substrate 12 is a silicon substrate, surfaces such as the first surface 13 of the substrate 12, the second surface 14 of the substrate 12, and the wall surface 21 may be constituted by an insulator layer. The insulator layer is formed, for example, by oxidatively treating the substrate 12 at high temperature with the through hole 20 formed therein.

A thickness T0 of the substrate 12 is for example 100 µm or greater, may be 150 µm or greater, or may be 200 µm or greater. When the thickness T0 is 100 µm or greater, the substrate 12 can be restrained from becoming greatly bent. For this reason, handling of the substrate 12 in a manufacturing process can be restrained from becoming difficult, and the substrate 12 can be restrained from warping due to internal stress of a layer that is formed on top of the substrate 12. The thickness T0 of the substrate 12 is for example 600 µm or less, may be 500 µm or less, or may be 400 µm or less. When the thickness T0 is 600 µm or less, lengthening of time required for a step of forming the through hole 20 in the substrate 12 can be restrained.

The wall surface 21 of the through hole 20 may extend along the thickness direction D1. Although not illustrated, the wall surface 21 may extend along a direction deviating from the thickness direction D1. For example, the wall surface 21 may include a portion that extends in a direction inclined with respect to the thickness direction D1 so that a dimension of the through hole 20 gradually decreases from the first surface 13 toward the second surface 14. On the other hand, the wall surface 21 may include a portion that extends in a direction inclined with respect to the thickness direction D1 so that the dimension of the through hole 20 gradually decreases from the second surface 14 toward the first surface 13. The wall surface 21 may include a portion that extends in a direction inclined with respect to the thickness direction D1 so that the dimension of the through hole 20 gradually decreases from the first surface 13 toward the center of the through hole 20 in the thickness direction D1 and a portion that extends in a direction inclined with respect to the thickness direction D1 so that the dimension of the through hole 20 gradually decreases from the second surface 14 toward the center of the through hole 20 in the thickness direction D1. A portion of the wall surface 21 may be curved.

Fig. 2 is an enlarged cross-sectional view of the through-via substrate. The through hole 20 has a dimension R1 at the first surface 13. The through hole 20 has a dimension R2 at the second surface 14. The dimension R1 may be identical to the dimension R2. The dimension R1 may be different from the dimension R2. For example, the dimension R1 may be larger than the dimension R2 or may be smaller than the dimension R2.

The dimension R1 is for example 5 µm or greater, may be 10 µm or greater, or may be 20 µm or greater. The dimension R1 is for example 100 µm or less, may be 80 µm or less, or may be 60 µm or less. The range of numerical values of the dimension R2 may be identical to the range of numerical values of the dimension R1.

A ratio T0/R1 of the thickness T0 to the dimension R1 is for example 3.0 or higher, may be 4.0 or higher, or may be 5.0 or higher. T0/R1 is for example 25.0 or lower, may be 20.0 or lower, or may be 15.0 or lower. For example, T0/R1 may be 3.0 or higher and 25.0 or lower. When T0/R1 is 3.0 or higher, a situation where the through hole 20 is not filled by the through via 22 at the first surface 13 can be restrained from occurring. When T0/R1 is 25.0 or lower, time required to form the through via 22 through a plating process can be reduced.

The shape of the through hole 20 in a plan view is not limited to particular shapes. For example, the shape of the through hole 20 in a plan view may be a circle or may not be a circle. In a case where the shape of the through hole 20 in a plan view is a circle, the aforementioned dimensions R1 and R2 are the diameter of the through hole 20 at the first surface 13 and the diameter of the through hole 20 at the second surface 14. In a case where the shape of the through hole 20 in a plan view is not a circle, the aforementioned dimensions R1 and R2 are defined in a direction in which a dimension of the through hole 20 in a plan view reaches its maximum. For example, in a case where the shape of the through hole 20 in a plan view is an ellipse, the aforementioned dimensions R1 and R2 are defined in a direction of the major axis of the ellipse.

### (Through Via)

The through via 22 is a member, located inside the through hole 20, that has electrical conductivity. The through via 22 is charged into the through hole 20. The through via 22 is a so-called filled via.

As shown in Fig. 1, the through via 22 may include a first end face 221 located at the first surface 13 and a second end face 222 located at the second surface 14. The first end face 221 may spread in flush with the first surface 13. The second end face 222 may spread in flush with the second surface 14.

As shown in Fig. 2, the through via 22 includes a seed layer 31, a first portion 23, and a second portion 24. As will be mentioned later, the first portion 23 is formed by a first plating process. The second portion 24 is formed by a second plating process that is executed after the first plating process. The through via 22 includes an interface 223 where the first portion 23 and the second portion 24 touch each other. The interface 223 traverses the through hole 20. The interface 223 may be constituted by a grain boundary of a material that constitutes the first portion 23.

The seed layer 31 spreads along the wall surface 21 in a circumferential direction of the through hole 20. Further, the seed layer 31 spreads along the wall surface 21 from the first surface 13 toward the second surface 14. The seed layer 31 spreads so as not to reach the second surface 14. That is, in the thickness direction D1, a dimension T11 of the seed layer 31 located in the through hole 20 is smaller than the thickness T0 of the substrate 12. A ratio T11/T0 of the dimension T11 to the thickness T0 is for example 0.025 or higher, may be 0.05 or higher, or may be 0.10 or higher. T11/T0 is for example 0.275 or lower, may be 0.25 or lower, or may be 0.20 or lower.

A thickness T12 of the seed layer 31 is for example 5 nm or greater, may be 10 nm or greater, may be 15 nm or greater, or may be 20 nm or greater. The thickness T12 of the seed layer 31 is for example 50 nm or less, may be 40 nm or less, or may be 30 nm or less. For example, the thickness T12 of the seed layer 31 may be 5 nm or greater and 50 nm or less. When the thickness T12 of the seed layer 31 is 5 nm or greater, a defect such as a pin hole can be retrained from being formed in the seed layer 31. Further, when the thickness T12 of the seed layer 31 is 5 nm or greater, a portion not covered by the seed layer 31 can be restrained from being formed on the wall surface 21. When the thickness T12 of the seed layer 31 is 50 nm or less, the first portion 23 can be restrained from becoming nonuniform in thickness. For example, the first portion 23 can be retrained from gradually decreasing in thickness from the wall surface 21 toward the center of the through hole 20 in a plan view. When the first portion 23 gradually decreases in thickness from the wall surface 21 toward the center of the through hole 20 in a plan view, the after-mentioned depression 223a tends to be formed. The thickness T12 of the seed layer 31 is defined in the center of the first portion 23 in the thickness direction D1.

A material of the seed layer 31 is selected so that the first portion 23 can be deposited on the seed layer 31. The material of the seed layer 31 may be identical to a material of the first portion 23 or may be different from the material of the first portion 23. The seed layer 31 may contain, for example, a metal material such as Cu, Ti, or Cr. The seed layer 31 may contain a compound of these metal materials. For example, the seed layer 31 may contain TiN. The seed layer 31 may include a plurality of layers. For example, the seed layer 31 may include a layer of TiN and a layer of Cu.

The seed layer 31 may contain the after-mentioned common metal material. The seed layer 31 may contain the after-mentioned superconducting material.

Although not illustrated, other layers such as a barrier layer and an adhesive layer may be provided between the wall surface 21 and the seed layer 31.

The barrier layer is provided to restrain metal elements contained, for example, in the seed layer 31, the first portion 23, and the second portion 24 from diffusing into the substrate 12. The barrier layer is constituted, for example, by titanium, titanium nitride, molybdenum, molybdenum nitride, tantalum, tantalum nitride, or a laminated product thereof.

The adhesive layer is provided to enhance the adhesion of the through via 22 to the wall surface 21. The adhesive layer is constituted, for example, by titanium, molybdenum, tungsten, tantalum, nickel, chromium, aluminum, a compound thereof, an alloy thereof, or a laminated product thereof.

The first portion 23 is formed by a precipitation reaction that involves the use of electric charge that is supplied from the seed layer 31. In the through hole 20, the first portion 23 covers the seed layer 31. For example, the first portion 23 extends from the first surface 13 in the thickness direction D1 to a position that is closer to the second surface 14 than the seed layer 31.

The first portion 23 may contain a metal material such as Cu, Au, Ag, Pt, Rh, Ni, Cr, or Pd. The first portion 23 may contain a compound of these metal materials. A metal material such as Cu, Au, Ag, Pt, Rh, Ni, Cr, or Pd or a compound of these metal materials are hereinafter also referred to as "common metal material".

The first portion 23 may contain a superconducting material. The superconducting material contains at least one element selected from the group consisting of Nb, Pb, Ta, Sn, In, and Al. In the superconducting material, a ratio of at least one element selected from the group consisting of Nb, Pb, Ta, Sn, In, and Al is for example 10% by mass or higher, may be 20% by mass or higher, or may be 30% by mass or higher. The superconducting material may contain a metal material such as Nb, Pb, Ta, Sn, In, and Al. The superconducting material may contain a compound of these metal materials.

The second portion 24 is in contact with the first portion 23 at the interface 223. The second portion 24 extends from the interface 223 to the second surface 14 in the thickness direction D1. The interface 223, which traverses the through hole 20, does not need to be flat. For example, the interface 223 may include a depression 223a depressed toward the first surface 13. A depth K of the depression 223a is for example 1.5 µm or greater, may be 3.0 µm or greater, or may be 5.0 µm or greater. The depth K of the depression 223a is for example less than 15 µm, may be less than 12 µm, or may be less than 10 µm. For example, the depth K of the depression 223a may be 1.5 µm or greater and less than 15 µm.

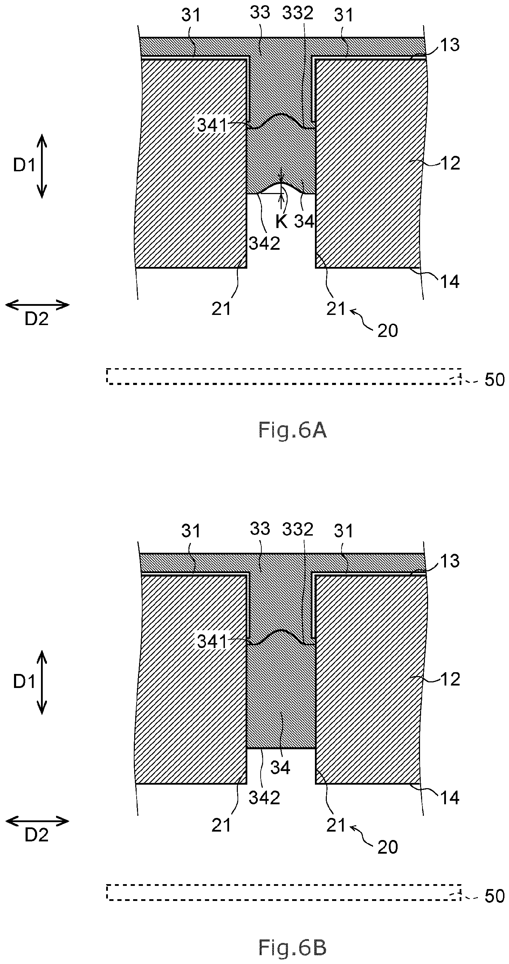

As shown in Figs. 6A to 7, the growth of a second plated portion 34 of the second portion 24 tends to further proceed in the center of the through hole 20 in a plan view than in the vicinity of the wall surface 21 of the through hole 20. Since the interface 223 includes the depression 223a, the second portion 24 can be restrained from excessively protrude from the second surface 14 in the center of the through hole 20 in a plan view. When the depth K of the depression 223a is less than 15 µm, a defect such as a void can be restrained from being formed during the growth of the second plated portion 34.

In the thickness direction D1, a dimension T21 of the first portion 23 may be smaller than a dimension T22 of the second portion 24. The dimension T21 and the dimension T22 may be defined by outer edges of the first portion 23 and the second portion 24 in the plane direction D2. For example, the dimension T21 and the dimension T22 may be defined by the positions of the first portion 23 and the second portion 24 touching the wall surface 21.

A ratio T21/T22 of the dimension T21 to the dimension T22 is for example 0.90 or lower, may be 0.80 or lower, or may be 0.70 or lower. T21/T22 may for example be 0.05 or higher, may be 0.10 or higher, or may be 0.20 or higher. For example, T21/T22 may be 0.05 or higher and 0.90 or lower. When T21/T22 is 0.05 or higher, the growth of the second plated portion 34 can be restrained from requiring excessive time or difficulty. When T21/T22 is 0.90 or lower, the first portion 23 can be restrained from becoming nonuniform in thickness.

As with the first portion 23, the second portion 24 may contain a common metal material. As with the first portion 23, the second portion 24 may contain a superconducting material.

A material of the second portion 24 may be identical to or different from the material of the first portion 23. For example, both the first portion 23 and the second portion 24 contain a common metal material or may contain a superconducting material. Alternatively, the first portion 23 may contain a superconductive material, and the second portion 24 may contain a common metal material. Alternatively, the first portion 23 may contain a common metal material, and the second portion 24 may contain a superconductive material.

### (First Wire)

The first wire 25 is connected to the through via 22. The first wire 25 is configured not to cover the through via 20 in a plan view. The first wire 25 extends in the plane direction D2. Since the first wire 25 does not cover the through hole 20, gas produced in the through hole 20 can be emitted from the through hole 20 at the first surface 13. As a result of this, pressure inside the through hole 20 can be restrained from increasing. For this reason, a phenomenon in which the first wire 25 deforms due to the pressure inside the through hole 20 can be restrained from occurring.

A thickness T3 of the first wire 25 is for example 1.0 µm or greater, may be 1.5 µm or greater, or may be 2.0 µm or greater. The thickness T3 is for example 5.0 µm or less, may be 4.5 µm or less, or may be 4.0 µm or less.

As with the first portion 23, the first wire 25 may contain a common metal material. As with the first portion 23, the first wire 25 may contain a superconducting material. A material of the first wire 25 may be identical to or different from the material of the first portion 23.

### (Post Pad)

The post pad 41 is located, for example, between the first wire 25 and the element 61 in the thickness direction D1. The post pad 41 may be connected to the terminal 62 of the element 61.

A thickness T4 of the post pad 41 is for example 1.0 µm or greater, may be 1.5 µm or greater, or may be 2.0 µm or greater. The thickness T4 is for example 5.0 µm or less, may be 4.5 µm or less, or may be 4.0 µm or less.

As with the first portion 23, the post pad 41 may contain a common metal material. As with the first portion 23, the post pad 41 may contain a superconducting material. A material of the post pad 41 may be identical to or different from the material of the first portion 23.

Any combination of materials of the seed layer 31, the first portion 23, the second portion 24, the first wire 25, and the post pad 41 may be adopted. Some examples of combinations of materials are shown in Table 1. In Table 1, the legend "Superconducting" means a superconducting material, and the legend "Common" means a common metal material.

**[Table 1]**

| | Seed layer | First portion | Second portion | First wire | Post pad |
|---|---|---|---|---|---|
| Example 1 | Superconducting | Superconducting | Superconducting | Superconducting | Superconducting |
| Example 2 | Common | Common | Common | Common | Common |
| Example 3 | Common | Superconducting | Superconducting | Superconducting | Superconducting |
| Example 4 | Common | Superconducting | Common | Superconducting | Superconducting |
| Example 5 | Common | Common | Superconducting | Superconducting | Superconducting |

The thickness T0, the dimension T11, the thickness T12, the dimension T21, the dimension T22, the thickness T3, the thickness T4, the dimension R1, the dimension R2, or other dimensions are calculated on the basis of an image of a cross-section of the through-via substrate 10 captured by a scanning electron microscope.

### (Method for Manufacturing Through-via Substrate)

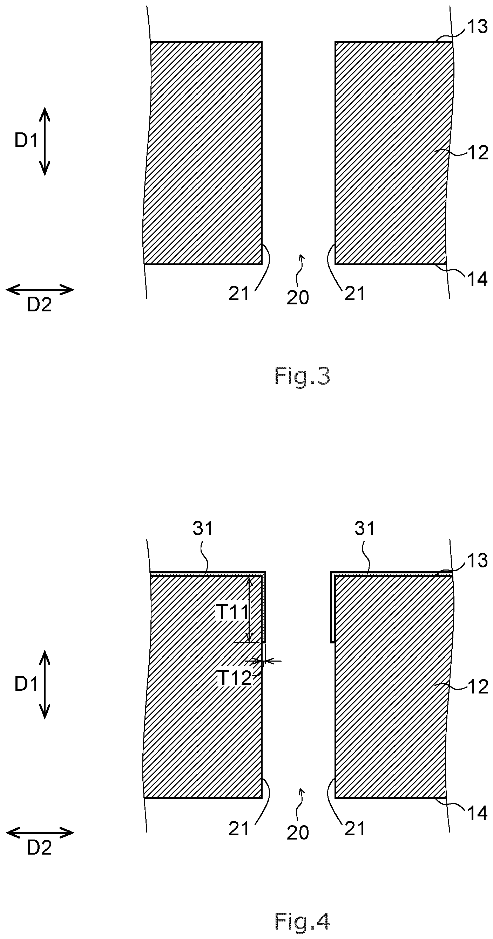

In the following, an example of a method for manufacturing a through-via substrate 10 is described with reference to Figs. 3 to 9.

### (Through-hole Forming Step)

First, a substrate 12 is prepared. Next, a resist layer is provided on at least either the first surface 13 or the second surface 14. After that, an opening is provided in a position in the resist layer that corresponds to a through hole 20. Next, the substrate 12 is processed in the opening of the resist layer. As a result of this, as shown in Fig. 3, the through hole 20 can be formed in the substrate 12. Usable examples of a method for processing the substrate 12 include a dry etching method and a wet etching method. Examples of the dry etching method include reactive-ion etching and deep-reactive ion etching.

The through hole 20 may be formed in the substrate 12 by irradiating the substrate 12 with a laser. In this case, the resist layer does not need to be provided. Usable examples of the laser include an excimer laser, a Nd:YAG laser, and a femtosecond laser. In a case where the Nd:YAG laser is employed, a fundamental wave having a wavelength of 1064 nm, a second harmonic having a wavelength of 532 nm, and a third harmonic having a wavelength of 355 nm can be used.

Laser irradiation and wet etching can be appropriately combined. Specifically, first, in a region of the substrate 12 in which the through hole 20 is to be formed, an altered layer is formed by laser irradiation. Then, the altered layer is etched by immersing the substrate 12 in hydrogen fluoride or other substances. As a result of this, the through hole 20 can be formed in the substrate 12.

Alternatively, the through hole 20 may be formed in the substrate 12 by blasting, by which an abrasive is sprayed onto the substrate 12.

### (Seed Layer Forming Step)

Next, as shown in Fig. 4, a seed layer 31 is formed on a wall surface 21 of the through hole 20. The seed layer 31 is formed by a physical film-forming method such as an evaporation method, a sputtering method, or an ion plating method.

An example of a method for adjusting the dimension T11 of the seed layer 31 is described.

A case where the seed layer 31 is formed by the evaporation method is described. In the evaporation method, a material of which the seed layer 31 is to be made comes flying onto the first surface 13. As a result of this, as shown in Fig. 4, the seed layer 31 spreading along the wall surface 21 from the first surface 13 toward the second surface 14 can be formed. The seed layer 31 is also formed over the first surface 13. By adjusting the duration of execution of the evaporation method, the angle of flight, or other conditions, the depth by which the seed layer 31 penetrates into the through hole 20 from the first surface 13, that is, the dimension T11 of the seed layer 31, can be controlled.

A case where the seed layer 31 is formed by the sputtering method or the ion plating method is described. First, the seed layer 31 is formed on the first surface 13 by the sputtering method or the ion plating method. As a result of this, the seed layer 31 spreading along the wall surface 21 from the first surface 13 toward the second surface 14 is formed inside the through hole 20 too. A dimension of the seed layer 31 in the thickness direction D1 is larger than the desired dimension T11. Then, a resist layer is formed on top of a portion of the seed layer 31 that is located inside the through hole 20 and that has the desired dimension T11. Then, an etching solution is supplied into the through hole 20 from the second surface 14 side. As a result of this, a portion of the seed layer 31 not covered by the resist layer is removed. In this way, the seed layer 31 having the desired dimension T11 can be formed inside the through hole 20.

### (First Plating Process Step)

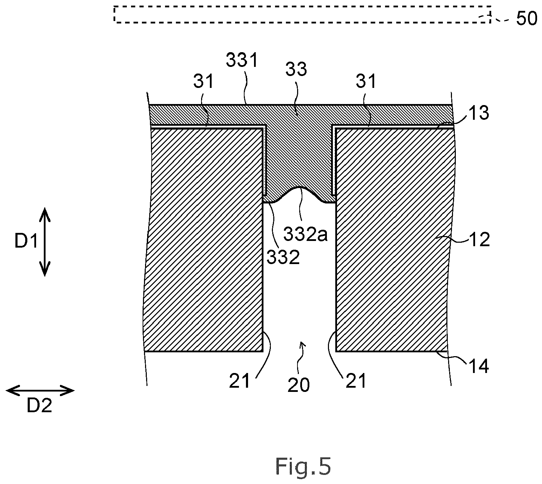

Then, a first plating process of supplying a first plating solution to the first surface 13 is executed. As shown in Fig. 5, a first plated portion 33 covering the seed layer 31 is formed by electrolytic plating. The seed layer 31 functions as a cathode. As indicated by dotted lines in Fig. 5, an anode 50 is placed so as to face the seed layer 31 over the first surface 13. The first plated portion 33 is formed not only inside the through hole 20 but also over the first surface 13.

The first plated portion 33 includes a third surface 331 and a fourth surface 332. The fourth surface 332 is located in the through hole 20. The fourth surface 332 may have a depression 332a depressed toward the first surface 13. The third surface 331 is located on the side opposite to the fourth surface 332 in the thickness direction D1. The third surface 331 may be located outside the through hole 20.

The first plating process is executed so that the through hole 20 is closed by the first plated portion 33 at the first surface 13. In this case, the fourth surface 332 spreads so as to traverse the through hole 20. The fourth surface 332 and the depression 332a constitute the aforementioned interface 223 and the aforementioned depression 223a.

The first plating solution may contain a common metal material such as Cu, Au, Ag, Pt, Rh, Ni, or Cr. The first plating solution may contain a superconducting material such as Nb, Pb, Ta, Sn, In, or Al. A concentration in the first plating solution of an element, such as a common metal material or a superconducting material, that constitutes a conducting material contained in the first plated portion 33 is also referred to as "first concentration". An electric current that is supplied to the seed layer 31 in the first plating process is also referred to as "first current".

The first plating solution may contain an accelerator that accelerates a precipitation reaction. The first plating solution may contain an inhibitor that inhibits a precipitation reaction.

### (Second Plating Process Step)

Then, a second plating process of supplying a second plating solution to the second surface 14 is executed. As shown in Fig. 6A, a second plated portion 34 is formed by electrolytic plating. Fig. 6B is a diagram showing a state in which the second plated portion 34 has further grown. As indicated by dotted lines in Figs. 6A and 6B, an anode 50 is placed so as to face the fourth surface 332 of the first plated portion 33. Such placement may be achieved by turning over the substrate 12 in a plating apparatus.

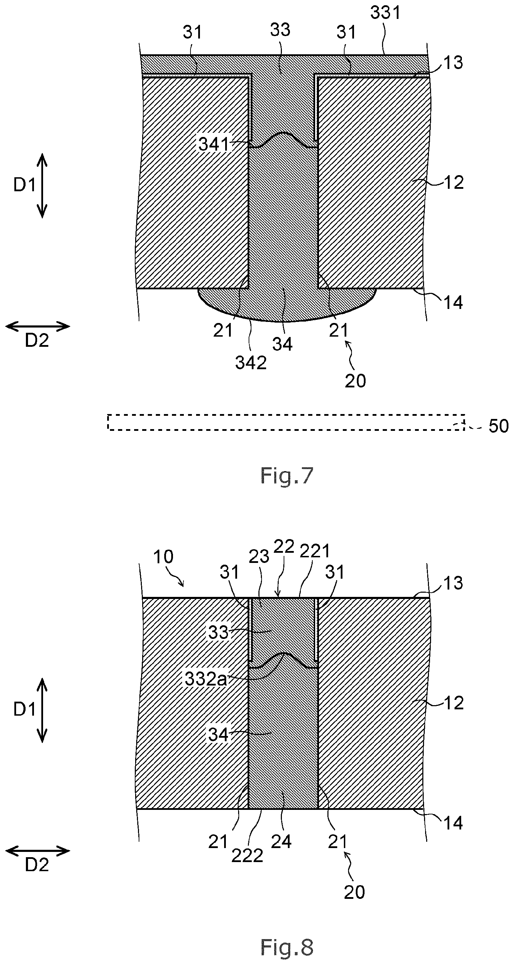

As shown in Figs. 6A and 6B, the wall surface 21 is provided with no seed layer between the seed layer 31 and the second surface 14. In this case, as shown in Figs. 6A and 6B, the second plated portion 34 grows in the thickness direction D1 from the first plated portion 33 toward the second surface 14. For this reason, the formation of a defect such as a void in the second plated portion 34 can be better restrained than in a case where the second plated portion 34 grows from the wall surface 21 toward the center of the through hole 20 in a plane direction. Fig. 7 is a cross-sectional view showing a state in which the second plated portion 34 has grown onto the second surface 14.

The second plated portion 34 includes a fifth surface 341 and a sixth surface 342. The fifth surface 341 is in contact with the fourth surface 332 of the first plated portion 33. The fourth surface 332 and the fifth surface 341 constitute the aforementioned interface 223. The sixth surface 342 is located on the side opposite to the fifth surface 341 in the thickness direction D1. The sixth surface 342 may be located outside the through hole 20.

As with the first plating solution, the second plating solution may contain a common metal material. As with the first plating solution, the second plating solution may contain a superconducting material. A concentration in the second plating solution of an element, such as a common metal material or a superconducting material, that constitutes a conducting material contained in the second plated portion 34 is also referred to as "second concentration". An electric current that is supplied to the seed layer 31 in the second plating process is also referred to as "second current".

The second concentration may be lower than the first concentration. As a result of this, the formation of a defect such as a void in the second plated portion 34 can be restrained.

The second current may be lower than the first current. As a result of this, the formation of a defect such as a void in the second plated portion 34 can be restrained.

The second plating solution may contain an accelerator that accelerates a precipitation reaction. A concentration of the accelerator that is contained in the second plating solution may be lower than a concentration of the accelerator that is contained in the first plating solution.

The second plating solution may contain an inhibitor that inhibits a precipitation reaction. A concentration of the inhibitor that is contained in the second plating solution may be higher than a concentration of the inhibitor that is contained in the first plating solution.

### (Removing Step)

Then, a removing step of removing an unnecessary plated portion may be executed.

For example, as shown in Fig. 8, a first removing step of removing a portion of the first plated portion 33 located over the first surface 13 may be executed. In the first removing step, the portion of the first plated portion 33 located over the first surface 13 may be removed by chemical-mechanical polishing. In the first removing step, a portion of the seed layer 31 located over the first surface 13 may be removed. The first removing step may give a first end face 221 that spreads in flush with the first surface 13.

For example, as shown in Fig. 8, a second removing step of removing a portion of the second plated portion 34 located over the second surface 14 may be executed. In the second removing step, the portion of the second plated portion 34 located over the second surface 14 may be removed by chemical-mechanical polishing. The second removing step may give a second end face 222 that spreads in flush with the second surface 14.

### (Wire Forming Step)

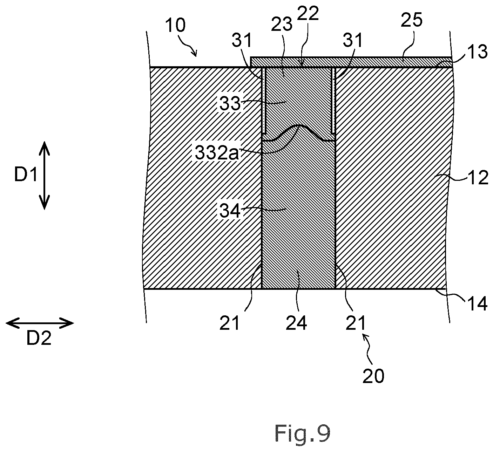

Then, as shown in Fig. 9, a fist wire forming step of forming a first wire 25 over the first surface 13 may be executed. The first wire 25 may be formed by any method. For example, first, a conductive layer is formed over the first surface 13 by the sputtering method. Then, a resist layer is formed over a portion of the conductive layer that corresponds to the first wire 25. Then, a portion of the conductive layer not covered by the resist layer is removed by etching or other processes. In this way, the first wire 25 including the conductive layer is formed over the first surface 13.

### (Post Pad Forming Step)

Then, a post pad forming step of forming a post pad 41 may be executed. The post pad 41 may be formed by any method. For example, as with the first wire 25, the post pad 41 may be formed by executing sputtering, formation of a resist layer, and etching. In this way, a through-via substrate 10 shown in Fig. 1 is obtained.

According to the present embodiment, the formation of a defect such as a void in the second portion 24 can be restrained. For this reason, a through-via substrate 10 including through vias 22 with reduced defects such as voids can be provided.

Various changes may be made to the aforementioned embodiment. The following describes modifications with reference to the drawings on an as-needed basis. In the following description and the drawings that are referred to in the following description, components that may be configured in a manner similar to those of the aforementioned embodiment are given reference signs that are identical to those given to the corresponding components of the first embodiment, and a repeated description of such components is omitted. Further, in a case where it is evident that the modifications bring about working effects that are brought about by the aforementioned embodiment, a description of such working effects may be omitted.

### (First Modification)

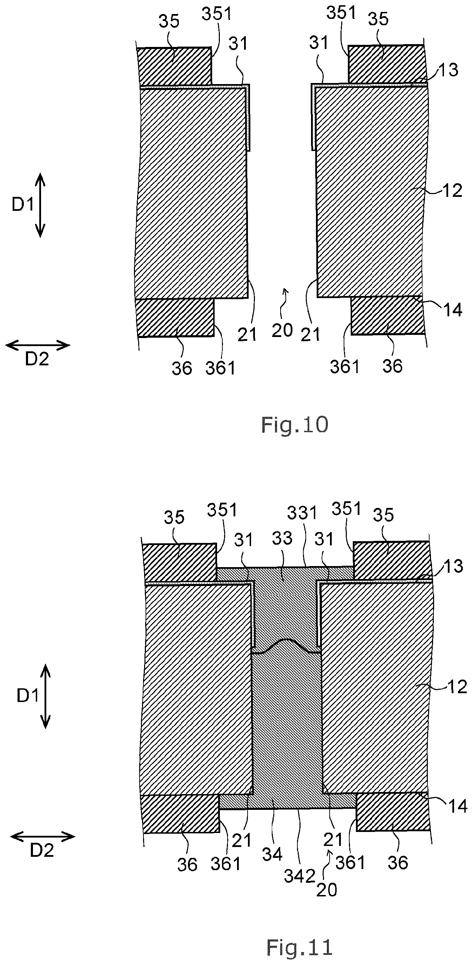

A method for manufacturing a through-via substrate 10 according to a first modification is described with reference to Figs. 10 to 13.

First, as in the case of the aforementioned embodiment, a seed layer 31 is formed in a substrate 12 provided with a through hole 20. Then, as shown in Fig. 10, a first resist layer 35 is formed over a portion of the seed layer 31 located over the first surface 13. The first resist layer 35 may include a side surface 351 that surrounds the through hole 20 in a plan view. Further, a second resist layer 36 may be formed over a portion of the second surface 14. The second resist layer 36 may include a side surface 361 that surrounds the through hole 20 in a plan view.

Then, as shown in Fig. 11, a first plating process of forming a first plated portion 33 is executed. The third surface 331 of the first plated portion 33 includes an outer edge surrounded by the first resist layer 35 in a plan view.

Then, as shown in Fig. 11, a second plating process of forming a second plated portion 34 is executed. The sixth surface 342 of the second plated portion 34 includes an outer edge surrounded by the second resist layer 36.

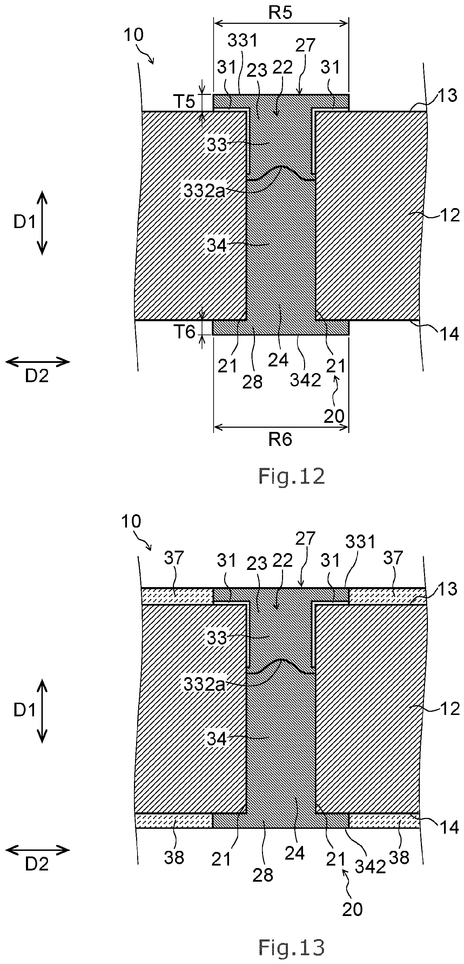

Then, as sown in Fig. 12, the first resist layer 35 and the second resist layer 36 are removed. Then, as shown in Fig. 12, a portion of the seed layer 31 which has been covered by the first resist layer 35 is removed. As a result of this, a through-via substrate 10 including a first pad 27 and a second pad 28 is obtained. The first pad 27 includes the first plated portion 33 and the seed layer 31. The second pad 28 includes the second plated portion 34.

The first pad 27 is located on the first surface 13 so as to cover the through hole 20 in a plan view. The first pad 27 is connected to the first portion 23 of the through via 22. The first plated portion 33 of the first pad 27 is integrated with the first plated portion 33 of the first portion 23 of the through via 22. That is, the first pad 27 is integrated with the first portion 23. Accordingly, a large portion of a material of the first pad 27 is identical to the material of the first portion 23. In a case where the first portion 23 contains a superconducting material, the first pad 27 too contains the superconducting material. In a case where the first portion 23 contains a common metal material, the first pad 27 too contains the common metal material.

A thickness T5 of the first pad 27 is for example 1.0 µm or greater, may be 1.5 µm or greater, or may be 2.0 µm or greater. The thickness T5 is for example 5.0 µm or less, may be 4.5 µm or less, or may be 4.0 µm or less.

A dimension R5 of the first pad 27 in a plan view is for example 10 µm or greater, may be 15 µm or greater, or may be 20 µm or greater. The dimension R5 is for example 100 µm or less, may be 80 µm or less, or may be 60 µm or less. The range of numerical values of a dimension R6 of the second pad 28 in a plan view may be identical to the range of numerical values of the dimension R5.

The second pad 28 is located on the second surface 14 so as to cover the through hole 20 in a plan view. The second pad 28 is connected to the second portion 24 of the through via 22. The second pad 28 is integrated with the second plated portion 34 of the second portion 24 of the through via 22. That is, the second pad 28 is integrated with the second portion 24. Accordingly, a large portion of a material of the second pad 28 is identical to the material of the second portion 24. In a case where the second portion 24 contains a superconducting material, the second pad 28 too contains the superconducting material. In a case where the second portion 24 contains a common metal material, the second pad 28 too contains the common metal material.

A thickness T6 of the second pad 28 is for example 1.0 µm or greater, may be 1.5 µm or greater, or may be 2.0 µm or greater. The thickness T6 is for example 5.0 µm or less, may be 4.5 µm or less, or may be 4.0 µm or less.

Then, as shown in Fig. 13, a first inorganic layer 37 may be formed. The first inorganic layer 37 is located on the first surface 13. The first inorganic layer 37 may be adjacent to the first pad 27 in the plane direction D2.

The first inorganic layer 37 contains an inorganic insulating material. Examples of the inorganic insulating material include SiN and SiO₂. The first inorganic layer 37 may include a layer of SiN and a layer of SiO₂.

The inorganic insulating material is higher in mechanical stability than an organic insulating material at low temperature. For example, a layer of the inorganic insulating material is less likely to suffer from defects such as cracks than a layer of the organic insulating material when there is a temperature change between low temperature and normal temperature. The low temperature is for example a temperature at which a superconducting phenomenon occurs. The temperature at which a superconducting phenomenon occurs is in the vicinity of absolute zero and, for example, is the temperature of liquid helium.

### (Second Modification)

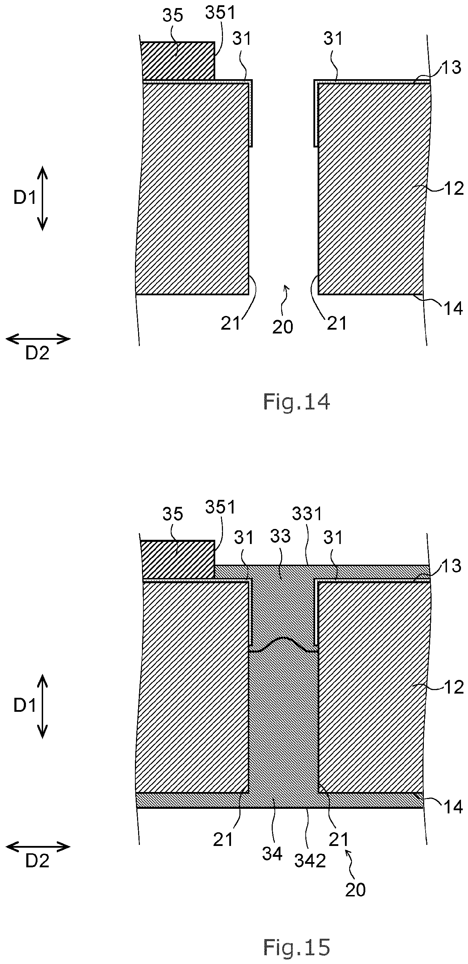

A method for manufacturing a through-via substrate 10 according to a second modification is described with reference to Figs. 14 to 16.

First, as in the case of the aforementioned embodiment, a seed layer 31 is formed in a substrate 12 provided with a through hole 20. Then, as shown in Fig. 14, a first resist layer 35 is formed over a portion of the seed layer 31 located over the first surface 13. The first resist layer 35 is formed so that a portion of the seed layer 31 located in a place where a first wire 25 is formed is exposed from the first resist layer 35.

Then, as shown in Fig. 15, a first plating process of forming a first plated portion 33 is executed. An outer edge of the third surface 331 of the first plated portion 33 is defined by the side surface 351 of the first resist layer 35.

Then, as shown in Fig. 15, a second plating process of forming a second plated portion 34 is executed.

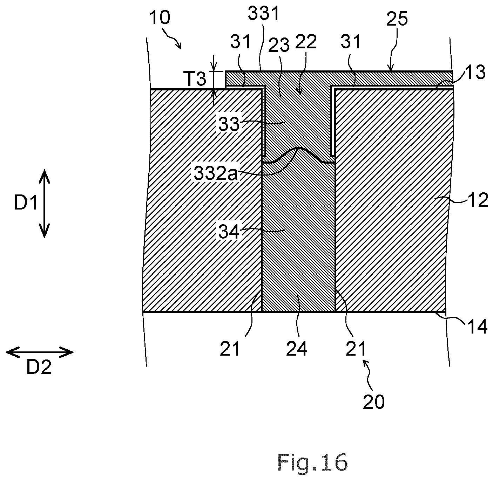

Then, as shown in Fig. 6, the first resist layer 35 is removed. Then, as shown in Fig. 16, a portion of the seed layer 31 which has been covered by the first resist layer 35 is removed. As a result of this, a through-via substrate 10 including a first wire 25 is obtained. The first wire 25 includes the first plated portion 33 and the seed layer 31. As in the case of the aforementioned embodiment, a second removing step of removing a portion of the second plated portion 34 located over the second surface 14 may be executed.

The first wire 25 may be located on the first surface 13 so as not to cover the through hole 20 in a plan view. The first wire 25 is connected to the first portion 23 of the through via 22. The first plated portion 33 of the first wire 25 is integrated with the first plated portion 33 of the first portion 23 of the through via 22. That is, the first wire 25 is integrated with the first portion 23. Accordingly, a large portion of the material of the first wire 25 is identical to the material of the first portion 23. In a case where the first portion 23 contains a superconducting material, the first wire 25 too contains the superconducting material. In a case where the first portion 23 contains a common metal material, the first wire 25 too contains the common metal material.

### (Examples of Products in Which Through-via Substrate Is Mounted)

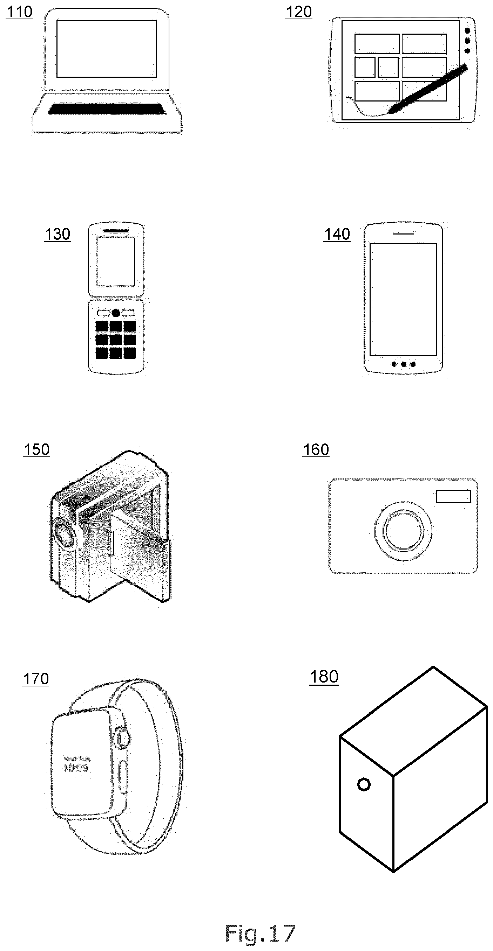

Fig. 17 is a diagram showing examples of products in which a through-via substrate 10 according to an embodiment of the present disclosure can be mounted. A through-via substrate 10 according to an embodiment of the present disclosure may be used in various products. For example, a through-via substrate 10 according to an embodiment of the present disclosure is mounted in a laptop personal computer 110, a tablet terminal 120, a mobile phone 130, a smartphone 140, a digital video camera 150, a digital camera 160, a digital watch 170, a server 180, or other products.

### EXAMPLES

Next, embodiments of the present disclosure are more specifically described by way of examples. The embodiments of the present disclosure are not limited to the following description of the examples, provided the embodiments of the present disclosure do not depart from the scope of the present disclosure.

### (Example 1)

A through-via substrate 10 shown in Fig. 2 was fabricated by the manufacturing process shown in Figs. 3 to 8.

Specifically, first, a substrate 12 having a diameter of 8 inches and a thickness T0 of 400 µm and consisted of silicon was prepared. Then, a large number of through vias 22 were formed in the substrate 12. Specifically, a hundred chip areas were formed on the substrate 12. Each chip area is a square area measuring approximately 12 mm one a side in a plan view. Each chip area includes a thousand through vias 22.

Each of the through vias 22 was formed by the following method. First, as shown in Fig. 3, a through hole 20 was formed in the substrate 12 by deep-reactive ion etching. The through hole 20 has a circular contour in a plan view. The dimensions R1 and R2 of the through hole 20 are 50 µm. Then, the substrate 12 was oxidatively treated at 1050°C with the through hole 20 formed therein. As a result of this, an insulator layer was formed on the first surface 13 of the substrate 12, the second surface 14 of the substrate 12, and the wall surface 21.

Then, an adhesive layer of Cr was formed on the wall surface 21. Then, as shown in Fig. 4, a seed layer 31 composed of Cu was formed by the evaporation method. The dimension T11 of the seed layer 31 in the thickness direction D1 was 50 µm. The thickness T12 of the seed layer 31 was 3 nm.

Then, as shown in Fig. 5, a first plated portion 33 composed of Cu was formed by electrolytic plating. Then, a first observing step of observing the shape of the first plated portion 33 was executed. Specifically, the shape of the first plated portion 33 was observed with an X-ray transmission apparatus. On the basis of an observation, for example, the flatness of the fourth surface 332 of the first plated portion 33 was evaluated.

Then, as shown in Figs. 6A to 7, a second plated portion 34 composed of Cu was formed by electrolytic plating. The plating process was continued until the thickness of a portion of the second plated portion 34 bulging out from the through hole 20 became 50 µm.

After that, an annealing step of heating the substrate 12 in a nitrogen atmosphere was executed. The annealing temperature was 250°C, and the annealing time was 1 hour.

Then, as shown in Fig. 8, a first removing step of removing a portion of the first plated portion 33 located over the first surface 13 and a second removing step of removing a portion of the second plated portion 34 located over the second surface 14 were executed. In this way, a through-via substrate 10 including through vias 22 was fabricated. Then, a second observing step of observing the shape of the through-via substrate 10 was executed. Specifically, the shapes of the through vias 22 were observed with an X-ray transmission apparatus. Further, on the basis of observations, the through vias 22 were checked for voids formed inside. A through via 22 having a void formed inside partly appears white. A through via 22 having a site that appears white was counted as a defective through via. The number of through vias 22 that are formed in one substrate 12 is one hundred thousand. In the second observing step, all through vias 22 were checked for voids.

### (Examples 2 to 18)

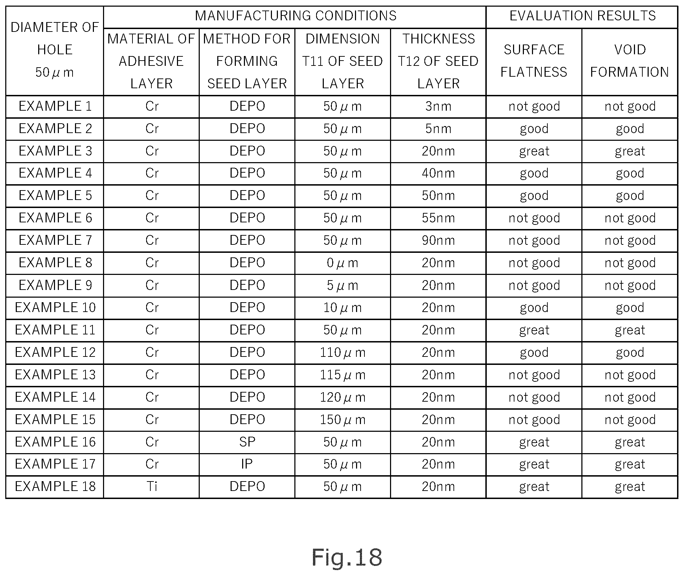

Through-via substrates 10 were fabricated under manufacturing conditions made different from those of Example 1. Further, as in the case of Example 1, the surface flatness of the first plated portions 33 was evaluated, and the through vias 22 were checked for voids. Results are shown in Fig. 18.

In the column "METHOD FOR FORMING SEED LAYER" of Fig. 18, the legend "DEPO" means that a seed layer 31 was formed by the evaporation method, the legend "SP" means that a seed layer 31 was formed by the sputtering method, the legend "IP" means that a seed layer 31 was formed by the ion plating method. In a case where a seed layer 31 was formed by the sputtering method or the ion plating method, an unnecessary portion of the seed layer 31 was removed by etching.

In the column "SURFACE FLATNESS" of Fig. 18, the legend "good" means that the maximum height of asperities on the surface of the fourth surface 332 of a first plated portion 33 was less than 15 µm, the legend "great" means that the maximum height of asperities on the surface of a fourth surface 332 was less than 10 µm, and the legend "not good" means that the maximum height of asperities on the surface of a fourth surface 332 was 15 µm or greater.

In the column "VOID FORMATION" of Fig. 18, the legend "good" means that the ratio (hereinafter also referred to as "void ratio") of the number of defective through vias to the number of through vias 22 observed was lower than 5%, the legend "great" means that the void ratio was 0%, and the legend "not good" means that the void ratio was 5% or higher.

As shown in Fig. 18, good results were obtained in cases where the dimensions T11 of seed layers 31 in the thickness direction D1 were 10 µm or greater and 110 µm or less and the thicknesses T12 of the seed layers 31 were 5 nm or greater and 50 nm or less. The thicknesses T0 of the substrates 12 are 400 µm. Accordingly, in examples in which good results were obtained, T11/T0 fall within the range of 0.025 to 0.275.

### (Example 19)

A through-via substrate 10 was fabricated under manufacturing conditions that are identical to those of Example 1 except that the dimensions R1 and R2 of each of the through holes 20 were 20 µm. Further, as in the case of Example 1, the surface flatness of the first plated portions 33 was evaluated, and the through vias 22 were checked for voids.

### (Examples 20 to 36)

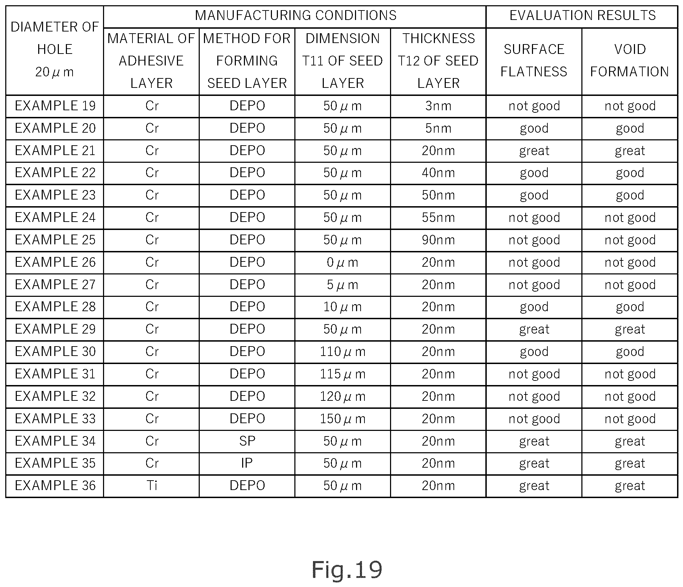

Through-via substrates 10 including through holes 20 having dimensions R1 and R2 of 20 µm were fabricated under manufacturing conditions made different from those of Example 19. The manufacturing conditions of Examples 20 to 36 correspond to the manufacturing conditions of Examples 2 to 18, respectively. Further, as in the case of Example 1, the surface flatness of the first plated portions 33 was evaluated, and the through vias 22 were checked for voids. Results are shown in Fig. 19.

As in the cases of Examples 1 to 18, good results were obtained in cases where the dimensions T11 of seed layers 31 in the thickness direction D1 were 10 µm or greater and 110 µm or less and the thicknesses T12 of the seed layers 31 were 5 nm or greater and 50 nm or less.

### (Examples 37 to 44)

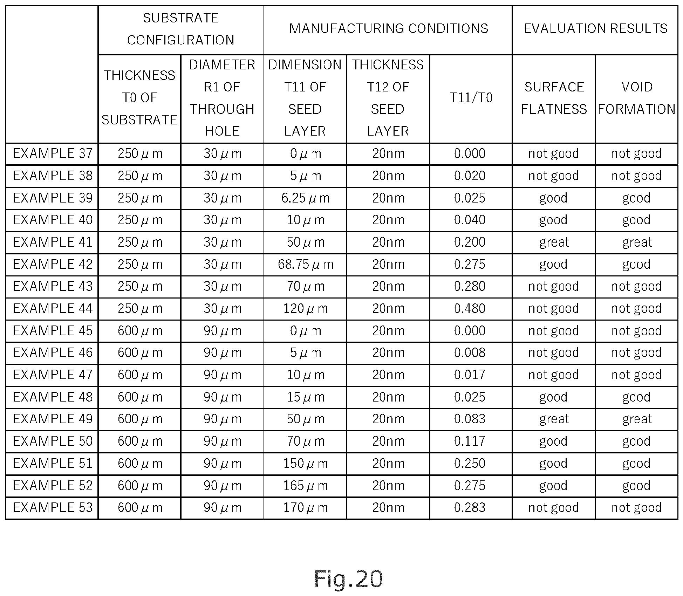

Substrates 12 each having a diameter of 8 inches and a thickness T0 of 250 µm and consisted of silicon were prepared. Then, as in the case of Example 1, a large number of through vias 22 were formed in each of the substrates 12. Each of the through holes 20 has a circular contour in a plan view. The dimensions R1 and R2 of the through hole 20 are 30 µm. Then, as in the case of Example 1, each of the through vias 22 was fabricated by executing steps of forming an insulator layer, an adhesive layer of Cr, a seed layer 31 composed of Cu, a first plated portion 33 composed of Cu, and a second plated portion 34 composed of Cu. In Examples 37 to 44, conditions of the evaporation method were adjusted so that the dimensions T11 in the thickness direction D1 of the seed layers 31 composed of Cu took on values shown in Fig. 20. Further, as in the case of Example 1, the surface flatness of the first plated portions 33 was evaluated, and the through vias 22 were checked for voids. Results are shown in Fig. 20.

As shown in Fig. 20, good results were obtained in cases where T11/T0 fell within the range of 0.025 to 0.275.

### (Examples 45 to 53)

Substrates 12 each having a diameter of 8 inches and a thickness T0 of 600 µm and consisted of silicon were prepared. Then, as in the case of Example 1, a large number of through vias 22 were formed in each of the substrates 12. Each of the through holes 20 has a circular contour in a plan view. The dimensions R1 and R2 of the through hole 20 are 90 µm. Then, as in the case of Example 1, each of the through vias 22 was fabricated by executing steps of forming an insulator layer, an adhesive layer of Cr, a seed layer 31 composed of Cu, a first plated portion 33 composed of Cu, and a second plated portion 34 composed of Cu. In Examples 45 to 53, conditions of the evaporation method were adjusted so that the dimensions T11 in the thickness direction D1 of the seed layers 31 composed of Cu took on values shown in Fig. 20. Further, as in the case of Example 1, the surface flatness of the first plated portions 33 was evaluated, and the through vias 22 were checked for voids. Results are shown in Fig. 20.

As shown in Fig. 20, good results were obtained in cases where T11/T0 fell within the range of 0.025 to 0.275.

### (Examples 54 to 62)

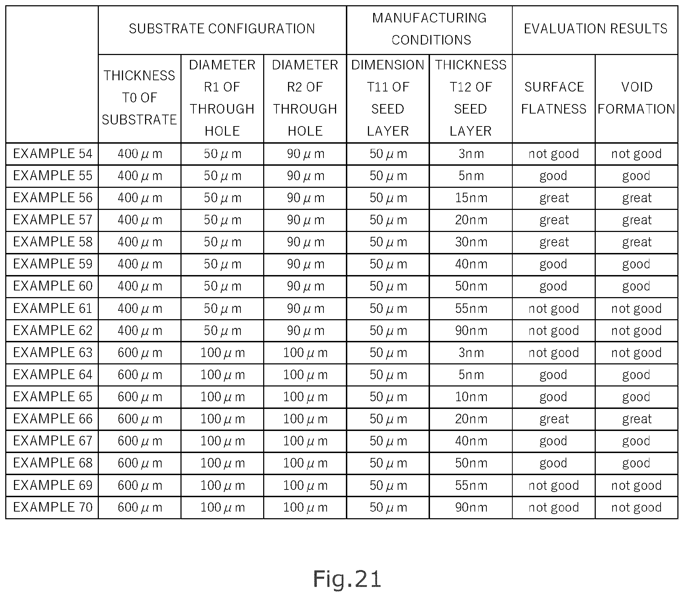

Substrates 12 each having a diameter of 8 inches and a thickness T0 of 400 µm and consisted of silicon were prepared. Then, as in the case of Example 1, a large number of through vias 22 were formed in each of the substrates 12. Each of the through holes 20 has a circular contour in a plan view. The through hole 20 has a diameter that gradually increases from the first surface 13 toward the second surface 14. The dimension R1 of the through hole 20 at the first surface 13 is 50 µm. The dimension R2 of the through hole 20 at the second surface 14 is 90 µm. Then, as in the case of Example 1, each of the through vias 22 was fabricated by executing steps of forming an insulator layer, an adhesive layer of Cr, a seed layer 31 composed of Cu, a first plated portion 33 composed of Cu, and a second plated portion 34 composed of Cu. In Examples 54 to 62, conditions of the evaporation method were adjusted so that the thicknesses T12 of the seed layers 31 composed of Cu took on values shown in Fig. 21. The thickness T12 12 is defined by the position of the center of the seed layer 31 in a thickness direction of the substrate 12. Further, as in the case of Example 1, the surface flatness of the first plated portions 33 was evaluated, and the through vias 22 were checked for voids. Results are shown in Fig. 21.

As shown in Fig. 21, good results were obtained in cases where the thicknesses T12 of seed layers 31 fell within the range of 5 nm to 50 nm.

### (Examples 63 to 70)

Substrates 12 each having a diameter of 8 inches and a thickness T0 of 600 µm and consisted of silicon were prepared. Then, as in the case of Example 1, a large number of through vias 22 were formed in each of the substrates 12. Each of the through holes 20 has a circular contour in a plan view. The through hole 20 has a diameter that gradually increases from the first surface 13 toward the second surface 14. The dimensions R1 and R2 of the through hole 20 are 100 µm. Then, as in the case of Example 1, each of the through vias 22 was fabricated by executing steps of forming an insulator layer, an adhesive layer of Cr, a seed layer 31 composed of Cu, a first plated portion 33 composed of Cu, and a second plated portion 34 composed of Cu. In Examples 63 to 70, conditions of the evaporation method were adjusted so that the thicknesses T12 of the seed layers 31 composed of Cu took on values shown in Fig. 21. The thickness T12 is defined by the position of the center of the seed layer 31 in a thickness direction of the substrate 12. Further, as in the case of Example 1, the surface flatness of the first plated portions 33 was evaluated, and the through vias 22 were checked for voids. Results are shown in Fig. 21.

As shown in Fig. 21, good results were obtained in cases where the thicknesses T12 of seed layers 31 fell within the range of 5 nm to 50 nm.

### Reference Signs List

- 10: through-via substrate
- 12: substrate
- 13: first surface
- 14: second surface
- 20: through hole
- 21: wall surface
- 22: through via
- 23: first portion
- 24: second portion
- 25: first wire
- 27: first pad
- 28: second pad
- 31: seed layer
- 33: first plated portion
- 331: third surface
- 332: fourth surface
- 332a: depression
- 34: second plated portion
- 35: first resist layer
- 36: second resist layer
- 37: first inorganic layer
- 38: second inorganic layer
- 41: post pad
- 60: mounting substrate
- 61: element
- 62: terminal

## Claims

1. A through-via substrate comprising:
a substrate including a first surface and a second surface located on a side opposite to the first surface, the substrate being provided with a through hole including a wall surface extending from the first surface to the second surface; and
a through via located in the through hole, the through via extending from the first surface to the second surface,
wherein the through via includes
a seed layer located on the wall surface, the seed layer spreading along the wall surface from the first surface toward the second surface,
a first portion covering the seed layer, and
a second portion touching the first portion at an interface traversing the through hole.

2. The through-via substrate according to claim 1, wherein a dimension of the first portion is smaller than a dimension of the second portion in a thickness direction of the substrate.

3. The through-via substrate according to claim 1, wherein a ratio T11/T0 of a dimension T11 of the seed layer in the thickness direction of the substrate to a thickness T0 of the substrate is 0.025 or higher and 0.275 or lower.

4. The through-via substrate according to claim 1, wherein the interface includes a depression depressed toward the first surface.

5. The through-via substrate according to any one of claims 1 to 4, wherein a ratio T0/R1 of a thickness T0 of the substrate to a dimension R1 of the through hole at the first surface is 3.0 or higher and 25.0 or lower.

6. The through-via substrate according to any one of claims 1 to 4, wherein a thickness of the seed layer is 5 nm or greater and 50 nm or less.

7. The through-via substrate according to any one of claims 1 to 4, wherein the first portion includes a superconducting material containing at least one element selected from the group consisting of Nb, Pb, Ta, Sn, In, and Al.

8. The through-via substrate according to any one of claims 1 to 4, wherein the second portion includes a superconducting material containing at least one element selected from the group consisting of Nb, Pb, Ta, Sn, In, and Al.

9. The through-via substrate according to any one of claims 1 to 4, further comprising a first pad located at the first surface so as to cover the through hole in a plan view and connected to the first portion.

10. The through-via substrate according to claim 9, wherein the first pad includes a superconducting material containing at least one element selected from the group consisting of Nb, Pb, Ta, Sn, In, and Al.

11. The through-via substrate according to claim 9, wherein the first pad is integrated with the first portion.

12. The through-via substrate according to claim 9, wherein the first pad covers the through hole in a plan view.

13. The through-via substrate according to claim 9, further comprising a first inorganic layer located on the first surface, the first inorganic layer being adjacent to the first pad in a plane direction and containing an inorganic insulating material.

14. The through-via substrate according to any one of claims 1 to 4, further comprising a first wire located on the first surface and connected to the first portion.

15. The through-via substrate according to claim 14, wherein the first wire includes a superconducting material containing at least one element selected from the group consisting of Nb, Pb, Ta, Sn, In, and Al.

16. The through-via substrate according to claim 14, wherein the first wire is integrated with the first portion.

17. A mounting substrate comprising:
the through-via substrate according to any one of claims 1 to 4; and
an element electrically connected to the through via of the through-via substrate.

18. The mounting substrate according to claim 17, wherein the element includes a quantum chip containing a quantum bit.

19. A method for manufacturing a through-via substrate, the method comprising:
a step of preparing a substrate including a first surface and a second surface located on a side opposite to the first surface, the substrate being provided with a through hole including a wall surface extending from the first surface to the second surface; and
a through-via forming step of forming a through via in the through hole,
wherein
the through-via forming step includes
a step of forming a seed layer located on the wall surface, the seed layer spreading along the wall surface from the first surface toward the second surface,
a step of forming a first plated portion through a first plating process that involves use of a first plating solution, the first plated portion covering the seed layer, and
a step of forming a second plated portion through a second plating process that involves use of a second plating solution, the second plated portion touching the first plated portion, and
the second plated portion touches the first plated portion at an interface traversing the through hole.

20. The method according to claim 19, wherein the first plating solution includes a superconducting material containing at least one element selected from the group consisting of Nb, Pb, Ta, Sn, In, and Al.

21. The method according to claim 19 or 20, wherein the second plating solution includes a superconducting material containing at least one element selected from the group consisting of Nb, Pb, Ta, Sn, In, and Al.
